# EUROPÄISCHE PATENTSCHRIFT

(11) **EP 3 376 547 B1**
(45) Veröffentlichungstag und Bekanntmachung des Hinweises auf die Patenterteilung: **27.03.2019**
(21) Anmeldenummer: 18000236.2
(22) Anmeldetag: 09.03.2018
(51) Int. Cl.: H01L 33/14, H01L 33/22

(54) **LEUCHTDIODE**
LIGHT DIODE
DIODE ÉLECTROLUMINESCENTE

(30) Priorität: 13.03.2017 DE 102017002333
(43) Veröffentlichungstag der Anmeldung: 19.09.2018
(73) Patentinhaber: AZUR SPACE Solar Power GmbH, 74072 Heilbronn (DE)
(72) Erfinder: Lauermann, Thomas, 74076 Heilbronn (DE); Köstler, Wolfgang, 74074 Heilbronn (DE); Fuhrmann, Bianca, 74081 Heilbronn (DE)
(74) Vertreter: Koch Müller Patentanwaltsgesellschaft mbH

(56) Entgegenhaltungen:
- DE-A1-102007 032 555
- DE-A1-102007 035 687
- DE-A1-102015 102 857
- US-A1- 2006 267 026
- US-A1- 2010 283 081
- US-A1- 2017 040 492
- JEON SEONG-RAN ET AL: "Lateral current spreading in GaN-based light-emitting diodes utilizing tunnel contact junctions", APPLIED PHYSICS LETTERS, A I P PUBLISHING LLC, US, Bd. 78, Nr. 21, 21. Mai 2001 (2001-05-21), Seiten 3265-3267, XP012028099, ISSN: 0003-6951, DOI: 10.1063/1.1374483

## Beschreibung

Die Erfindung betrifft eine Leuchtdiode.

Aus der DE 197 09 228 A1 ist eine Leuchtdiode bekannt, die zur Verbesserung der Lichtauskopplung texturierte Bereiche aufweist, wobei die Grenzflächentexturierung periodisch aufeinanderfolgende Berge und Täler aufweist.

Auch aus der DE 10 2007 032 555 A1 ist eine Leuchtdiode bekannt, die zur Verbesserung der Effizienz zwischen einer Kontaktschicht und einem aktiven Bereich eine Injektionsbarriere aufweist, wobei die Injektionsbarriere einen vertikalen Stromfluss vom Kontakt in Richtung des aktiven Bereichs unterdrückt.

Vor diesem Hintergrund besteht die Aufgabe der Erfindung darin, eine Vorrichtung anzugeben, die den Stand der Technik weiterbildet.

Die Aufgabe wird durch eine Leuchtdiode mit den Merkmalen des Patentanspruchs 1 sowie durch ein Verfahren mit den Merkmalen des Patentanspruchs 9 gelöst. Vorteilhafte Ausgestaltungen der Erfindung sind Gegenstand von Unteransprüchen.

Gemäß dem Gegenstand der Erfindung wird eine Leuchtdiode mit einer stapelförmigen Struktur mit einer Oberseite und einer Unterseite bereitgestellt.

Die stapelförmige überwiegend bestehend aus III-V-Halbleiterschichten bestehende Struktur weist an der Oberseite einen ersten Bereich und einen zweiten Bereich und einen dritten Bereich auf, wobei alle drei Bereiche die folgenden Halbleiterschichten in der genannten Reihenfolge aufweisen:
eine Trägerschicht und eine n-dotierte untere Mantelschicht und eine elektromagnetische Strahlung erzeugende aktive Schicht, wobei die aktive Schicht eine Quantentopfstruktur umfasst, und eine p-dotierte obere Mantelschicht.

Der erste Bereich weist zusätzlich eine auf der oberen Mantelschicht ausgebildete aus einer p⁺-Schicht und einer n⁺-Schicht gebildete Tunneldiode auf, wobei die p⁺-Schicht der Tunneldiode aus einem III-Arsenid besteht oder ein III- Arsenid umfasst und die n⁺-Schicht der Tunneldiode aus einem III-Phosphid besteht oder ein III- Phosphid umfasst.

Auch weist der erste Bereich eine n-dotierte Stromverteilerschicht, wobei die Stromverteilerschicht aus einem III-Arsenid besteht oder ein III-Arsenid umfasst.

Der erste Bereich weist eine n-dotierte Kontaktschicht auf, wobei die n-dotierte Kontaktschicht aus einem III-Arsenid besteht oder ein III-Arsenid umfasst.

Die n-dotierte Kontaktschicht ist mit einer Leiterbahn bedeckt.

Die für den ersten Bereich zusätzlich genannten Schichten sind in der genannten Reihenfolge angeordnet.

Zumindest die untere Mantelschicht, die aktive Schicht, die obere Mantelschicht, die Tunneldiode und die Stromverteilerschicht monolithisch ausgebildet.

Der zweite Bereich und der dritte Bereich weisen die zusätzlichen Schichten des ersten Bereichs nicht oder zumindest teilweise auf.

Der zweite Bereich weist ein Kontaktloch mit einem Bodenbereich auf, wobei in dem Bodenbereich des Kontaktlochs zusätzlich folgende Schichten ausgebildet sind:

Eine in der oberen Mantelschicht oder an der Oberfläche der oberen Mantelschicht oder oberhalb der oberen Mantelschicht flächig ausgebildete Injektionsbarriere, um einen Stromfluss entgegen der Stapelrichtung zu unterdrücken und eine Leiterbahn mit der die Injektionsbarriere bedeckt ist.

Der dritte Bereich ist texturiert ausgebildet, wobei die Textur Vertiefungen aufweist und die Vertiefungen vollständig durch die Stromverteilerschicht und durch die n⁺-Schicht der Tunneldiode reichen.

Es sei angemerkt, dass das Kontaktloch vorzugsweis einen planen Bodenbereich aufweist. Der Bodenbereich wird in einer Ausführungsform aus der oberen Mantelschicht gebildet.

In einer anderen Ausführungsform sind zumindest die Stromverteilerschicht und die n⁺-Phosphidschicht der Tunneldiode im Bereich des Bodens vollständig entfernt.

In einer weiteren Ausführungsform fehlt in dem Bodenbereich auch die p+-Arsenidschicht der Tunneldiode, d.h. die Tunneldiode ist in dem Bereich des Bodens vollständig entfernt.

Der Bereich des Kontaktlochs ist an der Oberseite vorzugsweise plan ausgebildet und dient als Padbereich zur elektrischen Kontaktierung der LED. Anders ausgedrückt der Padbereich wird mittels eines Bonddrahtes mit einem Anschluss der LED verschaltet.

Aufgrund der nahezu geschlossenen Metallisierungsschicht findet über den zweiten Bereich keine Lichtauskopplung statt.

Es versteht sich, dass über den dritten Bereich nahezu oder vollständig das gesamte Licht der LED ausgekoppelt wird.

Auch sei angemerkt, dass zwischen zwei unmittelbar benachbarten Vertiefungen eine Erhöhung ausgebildet ist. Während in dem Bodenbereich der Vertiefung zumindest die Stromverteilerschicht und die n⁺-Schicht der Tunneldiode vollständig entfernt sind, sind bei den Erhöhungen die n⁺-Schicht der Tunneldiode vollständig oder nahezu vollständig und die Stromverteilerschicht wenigstens teilweise oder nahezu vollständig vorhanden.

Des Weiteren sei angemerkt, dass die Bereiche an der Oberseite vorzugsweise aneinandergrenzen und dass insbesondere der zweite Bereich Kontaktschichten aufweist.

Es versteht sich, dass der erste Bereich keine oder fast keine Texturierung aufweist und zumindest teilweise von Kontaktschichten, vorzugsweise mit metallischen Kontaktschichten bedeckt ist.

Es versteht sich ferner, dass in dem dritten Bereich die Seitenwände der Erhöhungen vorzugsweise nicht senkrecht ausgebildet sind, und die Seitenwände einen Winkel kleiner als 90° zu der Ebene der Unterlage ausbilden.

Auch versteht es sich, dass die Einteilung der Oberfläche des Stapels in die drei Bereiche mittels eines Maskenprozesses durchgeführt wird.

Es sei angemerkt, dass unter dem Begriff "III-Arsenid" Halbleitermaterialien wie beispielsweise InGaAs oder GaAs oder AlGaAs verstanden werden.

Entsprechend werden unter dem Begriff "III-Phosphid" Halbleitermaterialien wie z.b. InGaP oder InAlP oder InP verstanden.

Es versteht sich, dass der Begriff der stapelförmigen Struktur aufeinander angeordnete Halbleiterschichten umfasst bzw. der Stapel aus den aufeinander angeordneten Halbleiterschichten besteht.

Vorzugsweise sind die Schichten beginnend von der unteren Mantelschicht bis einschließlich der n-dotierten Kontaktschicht mittels einer metalorganischen Gasphasen-Epitaxie (MOVPE) hergestellt. Je nach Herstellung lassen sich die monolithisch ausgebildeten Schichten auch auf eine Trägerschicht bonden.

Es versteht sich, dass die auf der aktiven Schicht aufliegenden weiteren Schichten, inklusive der Schichten der Tunneldiode möglichst transparent für die Emissionswellenlänge der aktiven Schicht ausgebildet sind.

Ein Vorteil der vorliegenden Struktur ist, dass sich die Lichtausbeute auf einfache und kostengünstige Weise erhöhen lässt. Zu einer Erhöhung der Lichtausbeute tragen unter anderen die texturierten dritten Bereiche bei, mit denen eine verbesserte Lichtauskopplung erreicht wird. Gleichzeitig wird mit dem vorliegenden Ansatz die Strominjektion im Bereich unterhalb des Bondpads auf einfache Weise minimiert, sodass eine erhöhte Effizienz des Bauteils erreicht wird. Es sei angemerkt, dass mit dem Begriff der Lichtausbeute der In mW gemessene Lichtstrom im Verhältnis zu der Leistungsaufnahme des LED-Bauelements verstanden ist.

Überraschenderweise zeigte sich, dass die oberste hochdotierte n⁺-Tunneldiodenphosphidschicht sich hochselektiv gegen eine Nassätzung verhält. Anders ausgedrückt, die Phosphidschicht stellt eine Ätzstoppschicht für die Nassätzung dar. Auch bei längerer Nassätzzeit wird die Phosphidschicht nicht weggeätzt.

Hierdurch lassen sich unterschiedliche Seitenwandprofile der Textur und die Höhe der Textur einstellen. Es versteht sich, dass mit einer Erhöhung der Ätzzeit die Seitenwände immer weiter zurückverlegt werden und letztlich sich die Höhe der Textur verringert. Vorzugsweise wird die Nassätzung mittels einer stark anisotrop wirkenden Nassätzlösung, beispielsweise mit einer Peroxid-Phosphorsäure durchgeführt. Hierbei sind die ersten Bereiche mittels einer Lackmaske gegen den Angriff der Nassätzlösung geschützt. Es versteht sich, dass anstelle einer Nassätzung auch ein Trockenätzprozess verwendet werden kann.

In einem anschließenden vorzugsweise als Nassätzschritt ausgebildeten Prozessschritt lässt sich die n⁺-Phosphidtunneldiodenschicht entfernen. Vorzugsweise lässt sich hierzu Salzsäure verwenden. Untersuchungen haben gezeigt, dass sich mit Salzsäure die n⁺-Phosphidtunneldiodenschicht sehr selektiv zu der unmittelbar darunter liegenden p⁺-Arsenidtunneldiodenschicht entfernen lässt. In einem weiteren Nassätzschritt lässt sich in einer Weiterbildung anschließend auch die vorher freigelegte p⁺-Arsenidtunneldiodenschicht entfernen.

Es zeigte sich überraschend, dass mit einem einzigen Maskenschritt mit anschließender Ätzung sich gleichzeitig sowohl die dritten texturierten Bereiche als auch der zweite das Kontaktloch ausbilden lässt.

Es sei angemerkt, dass es sehr vorteilhaft ist, nach der Ätzung eine Injektionsbarriere in dem Bodenbereich des zweiten Bereichs auszubilden.

Hierdurch lässt sich auf einfache, zuverlässige und kostengünstige Weise die Lichtausbeute, trotz Ätzung der n-dotierten Stromverteilerschicht und der n⁺-Schicht der Tunneldiode, wesentlich erhöhen. Anders ausgedrückt die Wirkung der Stromverteilerschicht wird durch die Ätzung nicht oder nur wenig beeinträchtigt.

In einer Weiterbildung umfasst oder besteht die Injektionsbarriere aus einem p/n Übergang und einer Isolationsschicht oder einem p/n-Übergang oder einer Isolationsschicht.

In einer Ausführungsform wird eine Metallschicht, die n-Dotierstoffe enthält, auf den Bodenbereich des Kontaktlochs eingebracht. Indem der Bodenbereich von der p⁺-Tunneldiodenschicht oder in einer Weiterbildung von der oberen Mantelschicht gebildet wird, lässt sich eine Injektionsbarriere in Form eines sperrenden p/n-Übergangs einfach und kostengünstig ausbilden.

In einer anderen Ausführungsform ist in dem Bereich des Bodens des Kontaktlochs und in den Vertiefungen der Textur eine AIGaAs Schicht ausgebildet.

In einer Weiterbildung ist zwischen der Trägerschicht und der unteren Mantelschicht eine Spiegelschicht angeordnet. Mittels der Spiegelschicht werden die in der aktiven Schicht entgegen der Stapelrichtung emittierten Photonen in Stapelrichtung zurückreflektiert. Hierdurch wird die Lichtausbeute erhöht.

Gemäß alternativen Ausführungsformen ist eine Unterseite der stapelförmigen Struktur aus der Trägerschicht oder aus einer mit der Trägerschicht verbundenen Kontaktschicht gebildet.

In einer anderen Weiterbildung reichen die Vertiefungen durch die gesamte Tunneldiode bis zu der oberen Mantelschicht. Anders ausgedrückt sind in dem Bodenbereich des zweiten Bereichs und in den Bodenbereichen des dritten Bereichs beide Tunneldiodenschichten und vollständig entfernt.

Gemäß alternativen Ausführungsformen sind die Vertiefungen polyederstumpfförmig ausgebildet oder weisen einen wannenförmigen Querschnitt auf.

Gemäß einer weiteren Ausführungsform weisen die Vertiefungen Hinterschneidungen auf.

In einer anderen Weiterbildung bestehen die untere Mantelschicht und die obere Mantelschicht aus einem III-Arsenid oder umfassen ein III-Arsenid.

Gemäß einem weiteren Gegenstand der Erfindung wird ein Herstellungsverfahren zur Erzeugung einer Leuchtdiode mit einem ersten Bereich und einem zweiten Bereich und einem dritten Bereich mit folgenden Verfahrensschritten bereitgestellt:
Bereitstellen einer stapelförmigen Struktur überwiegend bestehend aus III-V-Halbleiterschichten mit einer Oberseite und einer Unterseite,
wobei die stapelförmige Struktur einen die Unterseite ausbildenden Träger, eine untere Mantelschicht, eine elektromagnetische Strahlung erzeugende Schicht mit einer Quantentopfstruktur, eine p-dotierte obere Mantelschicht, eine aus einer p⁺-Schicht und einer n⁺-Schicht gebildete Tunneldiode und eine n-dotierte Stromverteilerschicht, und eine n-dotierten Kontaktschicht aufweist.

Die vorgenannten Halbleiterschichten der stapelförmigen Struktur sind in der genannten Reihenfolge angeordnet.

Die p⁺-Schicht der Tunneldiode und die Stromverteilerschicht und die n-dotierte Kontaktschicht umfassen jeweils ein III-Arsenid oder bestehen jeweils aus einem III-Arsenid.

Die n+-Schicht der Tunneldiode umfasst ein III-Phosphid oder besteht aus einem III-Phosphid.

Aufbringen und Strukturieren einer fotosensitiven Schicht auf die Oberseite der stapelförmigen Struktur während eines Maskenprozesses.

Anschließend ein anisotropes Atzen von Schichten, ausgehend von der Oberseite der stapelförmigen Struktur, wobei in dem zweiten Bereich ein Kontaktloch ausgebildet wird und mit einem gleichzeitigen Ätzen von Schichten in dem dritten Bereich zur Erzeugung einer Texturierung.

Bei der Ätzung dient bei beiden Bereichen, d.h. dem zweiten Bereich und dem dritten Bereich die phosphidhaltige n+-Schicht der Tunneldiode jeweils als Ätzstopp.

Ausbilden einer flächigen Injektionsbarriere in dem Bodenbereich des Kontaktloches und Abscheiden und Strukturieren einer Leiterbahn zur Auffüllung des Kontaktloches in dem zweiten Bereich und ausbilden von Anschlusskontaktfingern in dem ersten Bereich.

In einer Weitebildung werden die arsenidhaltige p⁺-Schicht der Tunneldiode in den Bodenbereichen des zweiten Bereichs und in dem Bodenbereich des dritten Bereichs entfernt.

In einer Ausführungsform wird die phosphidhaltige n+-Schicht der Tunneldiode an dem Boden des Kontaktloches und in den Vertiefungen der Texturierung entfernt wird.

In einer anderen Weiterbildung wird wenigstens ein Ätzschritt mittels einer Nassätzung unter Verwendung einer Peroxid-Phosphorsäure durchgeführt.

Es versteht sich, dass der Maskenprozess weitere Prozessschritte wie Belichtung und Entfernen des Lackes in den belichteten Gebieten umfasst. Bei letzterem wird von einem Positivlackprozess ausgegangen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und vertikalen Erstreckungen sind nicht maßstäblich und weisen, sofern nicht anders angegeben, auch keine ableitbaren geometrischen Relationen zueinander auf. Darin zeigten, die:
- Figur 1: eine Aufsicht auf eine erste erfindungsgemäße Ausführungsform einer Leuchtdiode,
- Figur 2A,B: Seitenansichten auf eine erste und zweite erfindungsgemäße Ausführungsform einer stapelförmigen Struktur einer Leuchtdiode,
- Figur 3 A-C: drei Ausführungsformen einer Texturierung,
- Figur 4: eine vierte Ausführungsform einer Texturierung,
- Figur 5: einen Schnittansicht entlang der Linie A-A aus Figur 1,
- Figur 6: eine Schnittansicht entlang der Linie B-B aus Figur 1,
- Figur 7: eine weitere Schnittansicht der Leuchtdiode aus Figur 1.

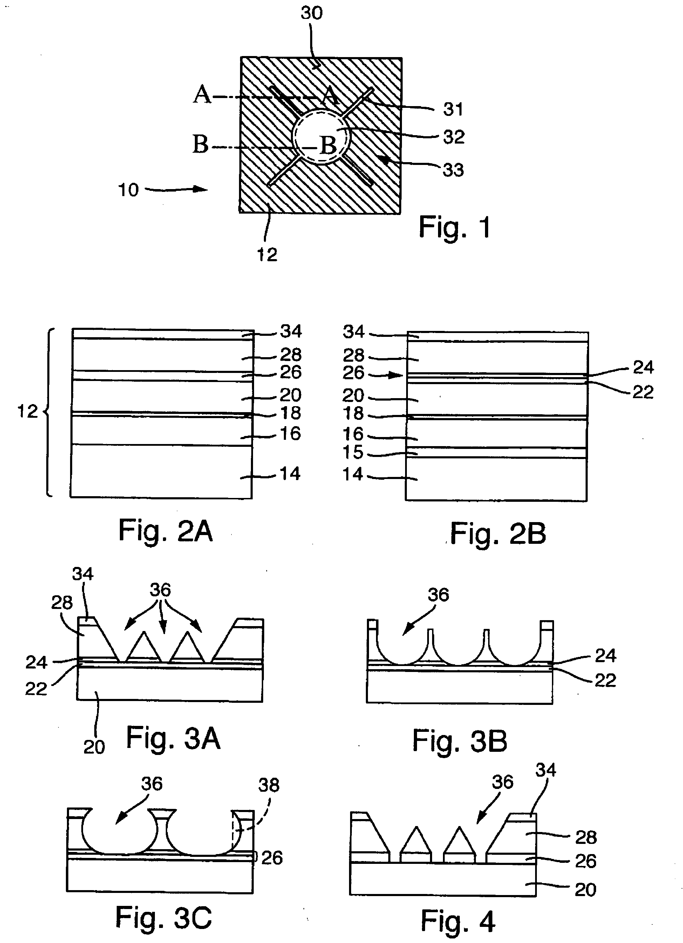

Die Abbildung der Figur 1 zeigt eine Aufsicht auf eine erste Ausführungsform einer erfindungsgemäßen Leuchtdiode 10, aufweisend eine im Wesentlichen aus III-V-Halbleitermaterialien bestehende stapelförmige Struktur 12, wobei eine Oberseite 30 einen ersten Bereich 31 und einen zweiten Bereich 32 und einen dritten Bereich 33 aufweist.

Der erste Bereich 31 ist als Ring mit vier sich von dem Ring weg erstreckenden Fingern ausgebildet. Der zweite Bereich 32 erstreckt sich über die von dem Ring eingeschlossene, kreisförmige Fläche. Die kreisförmige Fläche kennzeichnet ein mit einer metallischen Schichtenfolge gefülltes Kontaktloch. Der dritte Bereich 33 erstreckt sich über die restliche Fläche der Oberseite 30 der stapelförmigen Struktur 12 und ist texturiert.

Ein Aufbau der stapelförmigen Struktur 12 ist in der Abbildung der Figur 2A in einer seitlichen Ansicht dargestellt.

Die Struktur 12 weist eine Trägerschicht 14, eine n-dotierte untere Mantelschicht 16, eine elektromagnetische Strahlung erzeugende aktive Schicht 18 auf. Ferner weist die Struktur 12 eine p-dotierte obere Mantelschicht 20, eine aus einer p⁺-Schicht 22 und einer n⁺-Schicht 24 gebildete Tunneldiode 26 und eine n-dotierte Stromverteilerschicht 28 auf. Auf der Stromverteilerschicht 28 ist eine n-Kontaktschicht 34 angeordnet.

Die Schichten sind in der genannten Reihenfolge angeordnet. Die aktive Schicht 18 umfasst eine Quantentopfstruktur. Die Schichten sind monolithisch, d.h. die Schichten sind direkt auf der Trägerschicht aufgewachsen.

Die Abbildung der Figur 2B zeigt einen alternativen Aufbau der stapeiförmigen Struktur 12, wobei nur die Schichten von der unteren Mantelschicht 16 bis zu der n-Kontaktschicht 34 monolithisch sind. Zwischen der Trägerschicht 14 und den monolithischen Schichten ist eine Spiegelschicht 15 angeordnet.

Der erste Bereich 31 ist aus der n-dotierten Kontaktschicht 34 gebildet und dient zur Stromeinkopplung.

Der zweite Bereich 32 ist aus der oberen Mantelschicht 20 und der p⁺-Arsenidschicht 22 der Tunneldiode 26 gebildet, wobei sowohl die Stromverteilerschicht 28 sowie die n⁺-Phosphidschicht 24 der Tunneldiode 26 vollständig fehlen. In einer Weiterbildung wird der zweite Bereich 32 aus der oberen Mantelschicht 20 gebildet, wobei sowohl die Stromverteilerschicht 28 sowie die n⁺-Phosphidschicht 24 und die p⁺-Arsenidschicht der Tunneldiode 26 fehlen.

Die Texturierung des dritten Bereichs 33 dient der Steigerung der Lichtauskopplung.
Die Figuren der Abbildungen 3A, 3B und 3C zeigen unterschiedliche Ausgestaltungen der Texturierung in einer seitlichen Ansicht, wobei zur Vereinfachung alle unterhalb der oberen Mantelschicht 20 angeordneten Schichten nicht dargestellt sind. Die Texturierung weist Vertiefungen 36 auf, wobei die Vertiefungen durch die Stromverteilerschicht 28 und die n⁺-Schicht 24 der Tunneldiode 26 reichen.

Ein Querschnitt der Vertiefungen 36 ist kegelstumpfförmig oder alternativ wannenförmig ausgebildet. Gemäß der in der Figur 3C dargestellten Ausführungsform weist der Querschnitt der Vertiefungen 36 Hinterschneidungen 38 auf.

In der Abbildung der Figur 4 ist eine weitere Ausführungsform der Vertiefungen 36 des texturierten dritten Bereichs 33 skizziert, wobei die Vertiefungen 36 jeweils durch die Stromverteilerschicht 28 sowie durch die gesamte Tunneldiode 26 bis zu der unteren Mantelschicht 20 reichen.

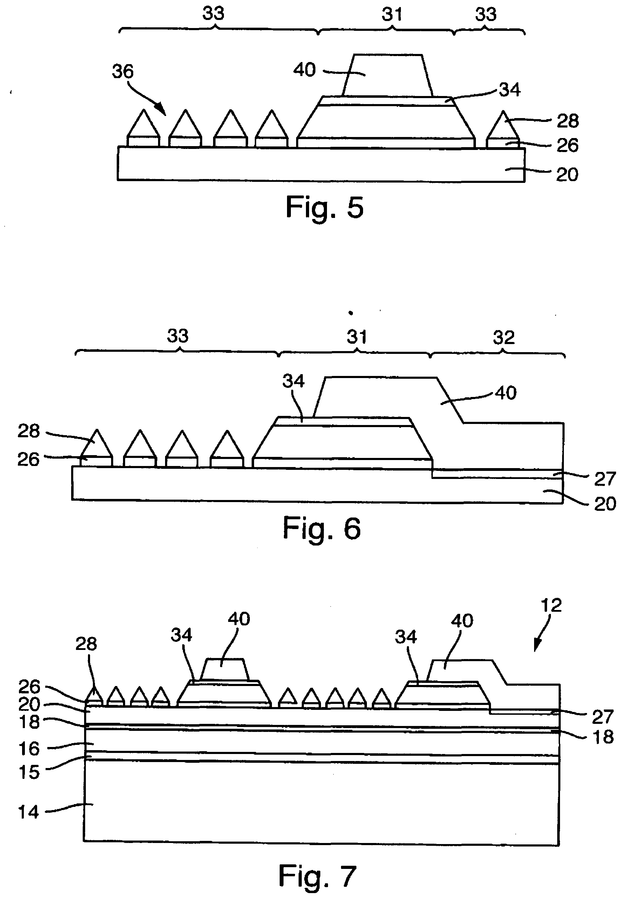

In der Abbildung der Figur 5 ist ein Schnitt entlang der Linien A-A der Figur 1 dargestellt. Im Folgenden werden nur die Unterschiede zu der Darstellung in der Figur 1 erläutert. Zur Vereinfachung der Darstellung sind sämtliche Schichten unterhalb der oberen Mantelschicht 20 angeordneten Schichten nicht dargestellt.

Zwischen dem texturierten dritten Bereich 33 ist ein Querschnitt des fingerförmigen ersten Bereichs 31 zu erkennen. Der erste Bereich 31 wird durch die n-dotierten Kontaktschicht 34 auf der Stromverteilerschicht 28 gebildet.

Auf dem ersten Bereich 31 ist eine Leiterbahn 40 angeordnet. Die Leiterbahn 40 ist Teil eines Vorderseitenkontakts der Leuchtdiode 10. Der dritte texturierte Bereich 33 wird durch Vertiefungen gebildet, die durch die Stromverteilschicht und die gesamte Tunneldiode 26 verlaufen.

In der Abbildung der Figur 6 ist ein Schnitt entlang der Linien B-B der Figur 1 dargestellt. Im Folgenden werden nur die Unterschiede zu der Darstellung in der Figur 1 erläutert. Zur Vereinfachung der Darstellung sind sämtliche Schichten unterhalb der oberen Mantelschicht 20 angeordneten Schichten nicht dargestellt.

An den texturierten dritten Bereich 33 mit bis zu der oberen Mantelschicht 20 reichenden Vertiefungen schließt sich der erste Bereich 31 an.

Zu erkennen ist ein Querschnitt der ringförmigen Struktur des ersten Bereichs 31, wobei der erste Bereich 31 durch die n-dotierten Kontaktschicht 34 gebildet ist, die auf der Stromverteilerschicht 28 angeordnet ist. An den ersten Bereich 31 schließt sich der von der oberen Mantelschicht 20 gebildete zweite Bereich 32 an, wodurch die Oberseite 30 der stapelförmigen Struktur im Bereich des Übergangs eine Stufe aufweist. Die Stufe stellt ein Teil eines Kontaktloches dar mit einem planen Bodenbereich. Im Bodenbereich des Kontaktloches ist eine Injektionsbarriere 27 ausgebildet, um einen Stromeintrag entgegen der Stapelrichtung zu unterdrücken. Vorzugsweise umfasst die Injektionsbarriere einen p/n Übergang.

Auf dem ersten und zweiten Bereich 31 und 32 ist ein elektrisch leitfähiges Material angeordnet, das sich auch über die Stufe erstreckt und einen weiteren Teil des Vorderseitenkontakts der Leuchtdiode 10 bildet.

Der Kontaktwiderstand zwischen dem elektrisch leitenden Material und dem zweiten Bereich 32 ist wenigstens 10-fach größer als der Kontaktwiderstand zwischen dem elektrisch leitfähigen Material und der Kontaktschicht 34. Hierdurch wird ein nach unten, in Richtung der aktiven Schicht 18 gerichteter, unerwünschter Stromfluss unterdrückt.

In der Abbildung der Figur 7 ein weiterer Schnitt einer erfindungsgemäßen Leuchtdiode 10 dargestellt.

Im Folgenden werden nur die Unterschiede zu der Darstellung in den vorhergehenden Figuren erläutert. Die stapelförmige Struktur 12 weist entsprechend der in Figur 2B dargestellten Ausführungsform eine Spiegelschicht 19 auf, die Vertiefungen 36 des texturierten dritten Bereichs reichen durch die gesamte Tunneldiode 26 bis zu der oberen Mantelschicht 20.

## Patentansprüche

1. Leuchtdiode (10) mit einer stapelförmigen Struktur (12) bestehend überwiegend aus III-V-Halbleiterschichten, aufweisend,
einen ersten Bereich (31) und einen zweiten Bereich (32) und einen dritten Bereich (33), wobei alle drei Bereiche (31, 32, 33) die nachfolgenden Halbleiterschichten in der genannten Reihenfolge aufweisen,
- eine Trägerschicht (14),
- eine n-dotierte untere Mantelschicht (16),
- eine elektromagnetische Strahlung erzeugende aktive Schicht (18),
- wobei die aktive Schicht (18) eine Quantentopfstruktur umfasst,
- eine p-dotierte obere Mantelschicht (20),
**dadurch gekennzeichnet, dass**
der erste Bereich (31) zusätzlich aufweist,
- eine auf der oberen Mantelschicht (20) ausgebildete aus einer p⁺-Schicht (22) und einer n⁺-Schicht (24) gebildete Tunneldiode (26), wobei die p⁺-Schicht (22) der Tunneldiode (26) aus einem III-Arsenid besteht oder ein III- Arsenid umfasst, und die n⁺-Schicht (24) der Tunneldiode (26) aus einem III-Phosphid besteht oder ein III- Phosphid umfasst,
- eine n-dotierte Stromverteilerschicht (28), wobei die Stromverteilerschicht (28) aus einem III-Arsenid besteht oder ein III-Arsenid umfasst,
- n-dotierten Kontaktschicht (34), wobei die n-dotierte Kontaktschicht (34) aus einem III-Arsenid besteht oder ein III-Arsenid umfasst, und
- die n-dotierte Kontaktschicht (34) mit einer Leiterbahn (40) bedeckt ist, und die für den ersten Bereich (31) zusätzlich genannten Schichten in der vorgenannten Reihenfolge angeordnet sind, und
wobei zumindest die untere Mantelschicht (16), die aktive Schicht (18), die obere Mantelschicht (20), die Tunneldiode (26) und die Stromverteilerschicht (28) monolithisch ausgebildet sind,
- der zweite Bereich (32) und der dritte Bereich (33) die zusätzlichen Schichten des ersten Bereichs (31) nicht oder teilweise aufweisen,
- der zweite Bereich (32) ein Kontaktloch mit einem Bodenbereich aufweist und in dem Bodenbereich des Kontaktlochs zusätzlich folgende Schichten ausgebildet sind,
- eine in der oberen Mantelschicht (20) oder an der Oberfläche der oberen Mantelschicht (20) oder oberhalb der oberen Mantelschicht (20) flächig ausgebildete Injektionsbarriere (27), um einen Stromfluss entgegen der Stapelrichtung zu unterdrücken,
- eine Leiterbahn (40) mit der die Injektionsbarriere (27) bedeckt ist,
- der dritte Bereich (33) texturiert ausgebildet ist, wobei die Textur Vertiefungen (36) aufweist und die Vertiefungen (36) vollständig durch die Stromverteilerschicht (28) und durch die n⁺-Schicht (24) der Tunneldiode (26) reichen.

2. Leuchtdiode (10) nach Anspruch 1, **dadurch gekennzeichnet, dass** in dem Bereich des Bodens des Kontaktlochs und in den Vertiefungen der Textur eine AlGaAs-Schicht ausgebildet ist.

3. Leuchtdiode (10) nach Anspruch 1 oder Anspruch 2, **dadurch gekennzeichnet, dass** die Injektionsbarriere (27) einen p/n Übergang und / oder eine Isolationsschicht umfasst oder aus einen p/n-Übergang oder einer Isolationsschicht besteht.

4. Leuchtdiode (10) nach einem der Ansprüche 1 bis 3, **dadurch gekennzeichnet, dass** zwischen der Trägerschicht (14) und der unteren Mantelschicht (16) eine Spiegelschicht (15) angeordnet ist.

5. Leuchtdiode (10) nach einem der Ansprüche 1 bis 4, **dadurch gekennzeichnet, dass** eine Unterseite der stapelförmigen Struktur (12) aus der Trägerschicht (14) oder aus einer mit der Trägerschicht (14) verbundenen Kontaktschicht gebildet ist.

6. Leuchtdiode (10) nach einem der Ansprüche 1 bis 5, **dadurch gekennzeichnet, dass** die Vertiefungen (36) durch die gesamte Tunneldiode (22) bis zu der oberen Mantelschicht (20) reichen.

7. Leuchtdiode (10) nach einem der Ansprüche 1 bis 6, **dadurch gekennzeichnet, dass** die Vertiefungen (36) polyederstumpfförmig ausgebildet sind.

8. Leuchtdiode (10) nach einem der Ansprüche 1 bis 7, **dadurch gekennzeichnet, dass** die Vertiefungen (36) einen wannenförmigen Querschnitt aufweisen.

9. Leuchtdiode (10) nach Anspruch 8, **dadurch gekennzeichnet, dass** die Vertiefungen Hinterschneidungen (38) aufweisen.

10. Leuchtdiode (10) nach einem der Ansprüche 1 bis 9, **dadurch gekennzeichnet, dass** die untere Mantelschicht (16) und die obere Mantelschicht (20) aus einem III-Arsenid bestehen oder ein III-Arsenid umfassen.

11. Herstellungsverfahren zur Erzeugung einer Leuchtdiode (10) mit einem ersten Bereich (31) und einem zweiten Bereich (32) und einem dritten Bereich (33) mit folgenden Verfahrensschritten:
- Bereitstellen einer stapelförmigen Struktur (12) mit einer Oberseite (30) und einer Unterseite (40), überwiegend bestehend aus III-V Halbleiterschichten,
- wobei die stapelförmige Struktur (12) ein die Unterseite ausbildenden Träger (14), eine untere Mantelschicht (16), eine aktive elektromagnetische Strahlung erzeugende Schicht (18) mit einer Quantentopfstruktur, eine p-dotierte obere Mantelschicht (20), eine aus einer p⁺-Schicht (22) und einer n⁺-Schicht (24) gebildete Tunneldiode (26), eine n-dotierte Stromverteilerschicht (28) und eine n-dotierte Kontaktschicht (34) aufweist, und die vorgenannten Halbleiterschichten in der genannten Reihenfolge ausgebildet sind, und
- die p⁺-Schicht (22) der Tunneldiode (26) und die Stromverteilerschicht (28) jeweils ein III-Arsenid umfassen oder aus einem III-Arsenid bestehen, und
- die n⁺-Schicht (24) der Tunneldiode (26) ein III-Phosphid umfasst oder aus einem III-Phosphid besteht,
- Aufbringen und strukturieren einer fotosensitiven Schicht auf die Oberseite (30) der stapelförmigen Struktur (12) während eines Maskenprozesses,
- anisotropes Atzen von Schichten, ausgehend von der Oberseite der stapelförmigen Struktur (12), in dem zweiten Bereich (32) zur Ausbildung eines Kontaktloches mit gleichzeitigem Ätzen von Schichten in dem dritten Bereich (33) zur Erzeugung einer Texturierung,
- wobei bei der Ätzung bei beiden Bereichen (32, 33) die phosphidhaltige n⁺-Schicht (24) der Tunneldiode (26) jeweils als Ätzstopp dient und
- Ausbilden einer flächigen Injektionsbarriere (27) in dem Bodenbereich des Kontaktloches und Abscheiden und strukturieren einer Leiterbahn (40) zur Auffüllung des Kontaktloches in dem zweiten Bereich (32) und ausbilden von Anschlusskontaktfingern in dem ersten Bereich (31).

12. Herstellungsverfahren nach Anspruch 11, **dadurch gekennzeichnet, dass** die phosphidhaltige n⁺-Schicht (24) der Tunneldiode (26) an dem Boden des Kontaktloches und in den Vertiefungen der Texturierung entfernt wird.

13. Herstellungsverfahren nach Anspruch 11 oder Anspruch 12, **dadurch gekennzeichnet, dass** wenigstens ein Ätzschritt mittels einer Nassätzung unter Verwendung einer Peroxid-Phosphorsäure durchgeführt wird.

## Claims

1. Light-emitting diode (10) with a stack-shaped structure (12) predominantly consisting of III-V semiconductor layers, comprising
a first region (31) and a second region (32) and a third region (33), wherein all three regions (31, 32, 33) have the following semiconductor layers in the stated sequence
- a carrier layer (14),
- an n-doped lower casing layer (16),
- an active layer (18) generating electromagnetic radiation,
- wherein the active layer (18) has a quantum-well structure,
- a p-doped upper casing layer (20),
**characterised in that**
the first region (31) additionally comprises
- a tunnel diode (26) constructed on the upper casing layer (20) and formed from a p⁺ layer (22) and an n⁺ layer (24), wherein the p⁺ layer (22) of the tunnel diode (26) consists of a III arsenide or comprises a III arsenide and the n⁺ layer (24) of the tunnel diode (26) consists of a III phosphide or comprises a III phosphide,
- an n-doped current distributor layer (28), wherein the current distributor layer (28) consists of a III arsenide or comprises a III arsenide,
- an n-doped contact layer (34), wherein the n-doped contact layer (34) consists of a III arsenide or comprises a III arsenide, and
- the n-doped contact layer (34) is covered by a conductor track (40) and the layers additionally stated for the first region (31) are arranged in the aforesaid sequence, and wherein at least the lower casing layer (16), the active layer (18), the upper casing layer (20), the tunnel diode (26) and the current distributor layer (28) are of monolithic construction,
- the second region (32) and the third region (33) do not have or partly have the additional layers of the first region (31),
- the second region (32) has a contact hole with a base region and in the base region of the contact hole the additional following layers are formed,
- an injection barrier (27), which is formed areally in the upper casing layer (20) or at the surface of the upper casing layer (20) or above the upper casing layer (20), in order to suppress a current flow opposite to the stack direction,
- a conductor track (40) by which the injection barrier (27) is covered,
- the third region (33) is formed to be textured, wherein the texture has depressions (36) and the depressions (36) reach completely through the current distributor layer (28) and through the n⁺ layer (24) of the tunnel diode (26).

2. Light-emitting diode (10) according to claim 1, **characterised in that** an AIGaAs layer is formed in the region of the base of the contact hole and in the depressions in the texture.

3. Light-emitting diode (10) according to claim 1 or 2, **characterised in that** the injection barrier (27) comprises a p/n transition and/or an insulation layer or consists of p/n transition or an insulation layer.

4. Light-emitting diode (10) according to any one of claims 1 to 3, **characterised in that** a mirror layer (15) is arranged between the carrier layer (14) and the lower casing layer (16).

5. Light-emitting diode (10) according to any one of claims 1 to 4, **characterised in that** a lower side of the stack-shaped structure (12) is formed from the carrier layer (14) or from a contact layer connected with the carrier layer (14).

6. Light-emitting diode (10) according to any one of claims 1 to 5, **characterised in that** the depressions (36) reach through the entire tunnel diode (22) as far as the upper casing layer (20).

7. Light-emitting diode (10) according to any one of claims 1 to 6, **characterised in that** the depressions (36) are of truncated polyhedron shape.

8. Light-emitting diode (10) according to any one of claims 1 to 7, **characterised in that** the depressions (36) have a trough-shaped cross-section.

9. Light-emitting diode (10) according to claim 8, **characterised in that** the depressions have undercuts (38).

10. Light-emitting diodes (10) according to any one of claims 1 to 9, **characterised in that** lower casing layer (16) and the upper casing layer (20) consist of a III arsenide or comprise a III arsenide.

11. Production method for production of a light-emitting diode (10) with a first region (31) and a second region (32) and a third region (33), with the following method steps:
- providing a stack-shaped structure (12) with an upper side (30) and a lower side (40), predominantly consisting of III-V semiconductor layers,
- wherein the stack-shaped structure (12) comprises a carrier (14) forming the lower side, a lower casing layer (16), an active layer (18), which produces electromagnetic radiation, with a quantum well structure, a p-doped upper casing layer (20), a tunnel diode (26) formed from a p⁺ layer (22) and an n⁺ layer (24), an n-doped current distributor layer (28) and an n-doped contact layer (34) and the aforesaid semiconductor layers are formed in the stated sequence, and
- the p⁺ layer (22) of the tunnel diode (26) and the current distributor layer (28) each comprise a III arsenide or consist of a III arsenide, and
- the n⁺ layer (24) of the tunnel diode (26) comprises a III phosphide or consists of a III phosphide,
- applying and structuring a photosenstive layer on the upper side (30) of the stack-shaped structure (12) during a masking process,
- anisotropic etching of layers, starting from the upper side of the stack-shaped structure (12) in the second region (32) for forming a contact hole with simultaneous etching of layers in the third region (33) for producing a texturing,
- wherein for the etching at the two regions (32, 33) the phosphide-containing n⁺ layer (24) of the tunnel diode (26) serves in each instance as etching stop and
- forming an areal injection barrier (27) in the base region of the contact hole and precipitating and structuring a conductor track (40) for filling up the contact hole in the second region (32) and forming connection contact fingers in the first region (31).

12. Production method according to claim 11, **characterised in that** the phosphide-containing n⁺ layer (24) of the tunnel diode (26) is removed at the base of the contact hole and in the depressions of the texturing.

13. Production method according to claim 11 or claim 12, **characterised in that** at least one etching step is carried out by means of wet etching with use of a peroxide phosphor acid.

## Revendications

1. Diode électroluminescente (10) avec une structure d'empilement (12) composée principalement de couches de semi-conducteurs III-V, présentant une première région (31) et une deuxième région (32) et une troisième région (33), dans laquelle les trois régions (31, 32, 33) présentent toutes les couches de semiconducteur suivantes dans l'ordre indiqué:
- une couche de support (14),
- une couche d'enveloppe inférieure à dopage n (16),
- une couche active (18) produisant un rayonnement électromagnétique,
- dans laquelle la couche active (18) comprend une structure de puits quantique,
- une couche d'enveloppe supérieure à dopage p (20),
**caractérisée en ce que**
la première région (31) présente en outre
- une diode tunnel (26) réalisée sur la couche d'enveloppe supérieure (20) et formée d'une couche p⁺ (22) et d'une couche n⁺ (24), dans laquelle la couche p⁺ (22) de la diode tunnel (26) est composée d'un arséniure-III ou comprend un arséniure-III, et la couche n⁺ (24) de la diode tunnel (26) est composée d'un phosphure-III ou comprend un phosphure-III,
- une couche de répartition de courant à dopage n (28), dans laquelle la couche de répartition de courant (28) est composée d'un arséniure-III ou comprend un arséniure-III,
- une couche de contact à dopage n (34), dans laquelle la couche de contact à dopage n (34) est composée d'un arséniure-III ou comprend un arséniure-III, et
- la couche de contact à dopage n (34) est couverte d'une piste conductrice (40), et les couches mentionnées en plus pour la première région (31) sont disposées dans l'ordre précité, et
dans laquelle au moins la couche d'enveloppe inférieure (16), la couche active (18), la couche d'enveloppe supérieure (20), la diode tunnel (26) et la couche de répartition de courant (28) sont réalisées sous forme monolithique,
la deuxième région (32) et la troisième région (33) ne présentent pas ou présentent partiellement les couches supplémentaires de la première région (31),
la deuxième région (32) présente un trou de contact avec une région de fond et les couches suivantes sont formées en plus dans la région de fond du trou de contact,
- une barrière d'injection (27) formée à plat dans la couche d'enveloppe supérieure (20) ou sur la surface de la couche d'enveloppe supérieure (20) ou au-dessus de la couche d'enveloppe supérieure (20), afin d'empêcher un flux de courant contrairement à la direction d'empilement,
- une piste conductrice (40) avec laquelle la barrière d'injection (27) est couverte, la troisième région (33) est réalisée sous forme texturée, dans laquelle la texture présente des creux (36) et les creux (36) passent entièrement à travers la couche de répartition de courant (28) et à travers la couche n⁺ (24) de la diode tunnel (26).

2. Diode électroluminescente (10) selon la revendication 1, **caractérisée en ce qu'**une couche AlGaAs est formée dans la région du fond du trou de contact et dans les creux de la texture.

3. Diode électroluminescente (10) selon la revendication 1 ou la revendication 2, **caractérisée en ce que** la barrière d'injection (27) comprend une transition p/n et/ou une couche d'isolation ou se compose d'une transition p/n ou d'une couche d'isolation.

4. Diode électroluminescente (10) selon l'une quelconque des revendications 1 à 3, **caractérisée en ce qu'**une couche réfléchissante (15) est disposée entre la couche de support (14) et la couche d'enveloppe inférieure (16).

5. Diode électroluminescente (10) selon l'une quelconque des revendications 1 à 4, **caractérisée en ce qu'**un côté inférieur de la structure d'empilement (12) est formée de la couche de support (14) ou d'une couche de contact assemblée à la couche de support (14).

6. Diode électroluminescente (10) selon l'une quelconque des revendications 1 à 5, **caractérisée en ce que** les creux (36) arrivent à travers toute la diode tunnel (22) jusqu'à la couche d'enveloppe supérieure (20).

7. Diode électroluminescente (10) selon l'une quelconque des revendications 1 à 6, **caractérisée en ce que** les creux (36) sont réalisés en forme de tronc de polyèdre.

8. Diode électroluminescente (10) selon l'une quelconque des revendications 1 à 7, **caractérisée en ce que** les creux (36) présentent une section transversale en forme de cuvette.

9. Diode électroluminescente (10) selon la revendication 8, **caractérisée en ce que** les creux présentent des contre-dépouilles (38).

10. Diode électroluminescente (10) selon l'une quelconque des revendications 1 à 9, **caractérisée en ce que** la couche d'enveloppe inférieure (16) et la couche d'enveloppe supérieure (20) se composent d'un arséniure-III ou comprennent un arséniure-III.

11. Procédé de fabrication pour la production d'une diode électroluminescente (10) avec une première région (31) et une deuxième région (32) et une troisième région (33), présentant les étapes de procédé suivantes:
- préparer une structure d'empilement (12) avec un côté supérieur (30) et un côté inférieur (40), se composant principalement de couches de semi-conducteurs III-V,
- dans lequel la structure d'empilement (12) présente un support (14) formant le côté inférieur, une couche d'enveloppe inférieure (16), une couche active (18) avec une structure de puits quantique, produisant un rayonnement électromagnétique, une couche d'enveloppe supérieure à dopage p (20), une diode tunnel (26) formée d'une couche p⁺ (22) et d'une couche n⁺ (24), une couche de répartition de courant à dopage n (28) et une couche de contact à dopage n (34), et les couches de semi-conducteurs précitées sont formées dans l'ordre indiqué, et
- la couche p⁺ (22) de la diode tunnel (26) et la couche de répartition de courant (28) comprennent respectivement un arséniure-III ou se composent d'un arséniure-III, et
- la couche n⁺ (24) de la diode tunnel (26) comprend un phosphure-III ou se compose d'un phosphure-III,
- déposer et structurer une couche photosensible sur le côté supérieur (30) de la structure d'empilement (12) pendant un processus de masquage,
- graver des couches de façon anisotrope, en partant du côté supérieur de la structure d'empilement (12), dans la deuxième région (32) pour former un trou de contact avec gravure simultanée de couches dans la troisième région (33) pour produire une texturation,
- dans laquelle, lors de la gravure des deux régions (32, 33), la couche n⁺ contenant du phosphure (24) de la diode tunnel (26) sert chaque fois d'arrêt de gravure, et
- former une barrière d'injection à plat (27) dans la région de fond du trou de contact et déposer et structurer une piste conductrice (40) pour combler le trou de contact dans la deuxième région (32) et former des doigts de contact de raccordement dans la première région (31).

12. Procédé de fabrication selon la revendication 11, **caractérisé en ce que** la couche n⁺ contenant du phosphure (24) de la diode tunnel (26) est enlevée sur le fond du trou de contact et dans les creux de la texturation.

13. Procédé de fabrication selon la revendication 11 ou la revendication 12, **caractérisé en ce que** l'on exécute au moins une étape de gravure au moyen d'une gravure humide avec utilisation d'un acide phosphorique avec peroxyde.
